# EUROPEAN PATENT APPLICATION

(11) **EP 4 646 055 A1**
(43) Date of publication of application: **05.11.2025**
(21) Application number: 24205142.3
(22) Date of filing: 08.10.2024
(51) Int. Cl.: H10D 84/00, H10D 1/66, H10D 84/80, H10D 86/00, H10D 62/10, H10D 87/00, H10D 1/62

(54) **HIGH-DENSITY STACKED CAPACITOR AND METHOD**

(30) Priority: 29.04.2024 US 202418648658
(71) Applicant: GlobalFoundries U.S. Inc., Malta, NY 12020 (US)
(72) Inventor: Zhang, Chi, Richardson, 75081 (US); Singa Reddy, Abhimanyu Reddy, 560045 Bangalore (IN); Meza Campos, Miguel Angel, Richardson, 75094 (US); Balasubramaniyan, Arul, Richardson, 75094 (US); Bellaouar, Abdellatif, Richardson, 75082 (US); Syed, Shafiullah, Richardson, 75094 (US)
(74) Representative: Grünecker Patent- und Rechtsanwälte PartG mbB

(57) **Abstract**

Disclosed are a semiconductor structure (1) and method of forming the semiconductor structure. The semiconductor structure includes a high-density stacked capacitor (100) and, particularly, a stack of capacitors connected in parallel between two nodes (191, 192). The stack includes a diode-type capacitor (181, also referred to herein as a PN junction capacitor) within a semiconductor substrate (101). In different embodiments, the diode-type capacitor has different in-substrate well configurations. The stack also includes a transistor-type capacitor (182, e.g., a metal oxide semiconductor capacitor (MOSCAP)) on an insulator layer (103) aligned above the diode-type capacitor. Optionally, the stack also includes at least one additional capacitor (e.g., at metal-oxide-metal capacitor (MOMCAP)) on a dielectric layer aligned above the transistor-type capacitor (e.g., in one or more back end of the line (BEOL) metal levels).

## Description

### BACKGROUND

The present disclosure relates to capacitors and, more particularly, to embodiments of a high-density stacked capacitor and method of forming the high-density stacked capacitor.

High-density capacitors serve a variety of different functions on integrated circuit (IC) chips. For example, high-density capacitors are used as bypass capacitors in filters (e.g., analog baseband filters or phase locked loop (PLL) filters). They are also used as compensation capacitors in operational amplifiers (op-amps) or used for setting the bandwidth in transimpedance amplifiers (TIAs). As ICs are scaled in size, it would be advantageous to have capacitor structures that consume less chip area while exhibiting larger capacitance values.

### SUMMARY

Disclosed herein are embodiments of a semiconductor structure including a high-density stacked capacitor. Generally, in each of the disclosed embodiments, the high-density stacked capacitor can include a diode-type capacitor in a semiconductor substrate, an insulator layer on the semiconductor substrate and a transistor-type capacitor on the insulator layer aligned above and connected in parallel with the diode-type capacitor.

More particularly, some embodiments of a semiconductor structure disclosed herein can include a semiconductor substrate with a first type conductivity, an insulator layer on the semiconductor substrate, and a semiconductor layer on the insulator layer. The semiconductor structure can further include a high-density stacked capacitor. This high-density stacked capacitor can include a first node, which is connected to the semiconductor substrate, and a second node. The high-density stacked capacitor can further include a diode-type capacitor in the semiconductor substrate and a transistor-type capacitor on the insulator layer aligned above and connected in parallel with the diode-type capacitor. The diode-type capacitor can include a well region, which is in the semiconductor substrate adjacent to the insulator layer, which is electrically connected to the second node, and which has a second type conductivity different from the first type conductivity. The transistor-type capacitor can include a channel region in the semiconductor layer positioned laterally between source/drain regions and a gate adjacent to the semiconductor layer at the channel region. In the transistor-type capacitor, the source/drain regions can be connected to the first node and the gate can be connected to the second node.

Other embodiments of a semiconductor structure disclosed herein can similarly include a semiconductor substrate with a first type conductivity, an insulator layer on the semiconductor substrate, and a semiconductor layer on the insulator layer. The semiconductor structure can further include a high-density stacked capacitor. The high-density stacked capacitor can include a first node, which is connected to the semiconductor substrate, and a second node. The high-density stacked capacitor can further include a diode-type capacitor in the semiconductor substrate and a transistor-type capacitor on the insulator layer aligned above and connected in parallel with the diode-type capacitor. In these embodiments, the diode-type capacitor can include multiple well regions. The well regions of the diode-type capacitor can include a first well region, which is in the semiconductor substrate adjacent to the insulator layer, which has the first type conductivity, and which is connected to the first node. The well regions can further include a second well region, which is in the semiconductor substrate laterally surrounding the first well region, which has a second type conductivity different from the first type conductivity, and which is connected to the second node. The well regions can further include a third well region, which is in the semiconductor substrate below and immediately adjacent to the first well region and the second well region and which has the second type conductivity. The transistor-type capacitor can include a channel region in the semiconductor layer positioned laterally between source/drain regions and a gate adjacent to the semiconductor layer at the channel region. In the transistor-type capacitor, the source/drain regions can be connected to the first node and the gate can be connected to the second node.

It should be noted that all aspects, examples, and features of disclosed embodiments mentioned in the summary above can be combined in any technically possible way. That is, two or more aspects of any of the disclosed embodiments, including those described in this summary section, may be combined to form implementations not specifically described herein. The details of one or more implementations are set forth in the accompanying drawings and the description below. Other features, objects and advantages will be apparent from the description and drawings, and from the claims.

### BRIEF DESCRIPTION OF THE DRAWINGS

The present disclosure will be better understood from the following detailed description with reference to the drawings, which are not necessarily drawn to scale and in which:
FIGs. 1A-1B are different cross-section diagrams illustrating a disclosed embodiment of a semiconductor structure including a high-density stacked capacitor;
FIGs. 2A-2C are different cross-section diagrams illustrating another disclosed embodiment of a semiconductor structure including a high-density stacked capacitor;
FIGs. 3A-3B are different cross-section diagrams illustrating yet another disclosed embodiment of a semiconductor structure including a high-density stacked capacitor;
FIGs. 4A-4C are different cross-section diagrams illustrating yet another disclosed embodiment of a semiconductor structure including a high-density stacked capacitor;
FIGs. 5 and 6 are cross-section diagrams illustrating alternative in-substrate well configurations for a diode-type capacitor that could be incorporated into a high-density stacked capacitor; and
FIG. 7 is an illustrative flow diagram of disclosed embodiments of a method of forming a semiconductor structure with a high-density stacked capacitor.

### DETAILED DESCRIPTION

As mentioned above, high-density capacitors serve a variety of different functions on integrated circuit (IC) chips. For example, high-density capacitors are used as bypass capacitors in filters (e.g., analog baseband filters or phase locked loop (PLL) filters). They are also used as compensation capacitors in operational amplifiers (op-amps) or used for setting the bandwidth in transimpedance amplifiers (TIAs). As ICs are scaled in size, it would be advantageous to have capacitor structures that consume less chip area while exhibiting larger capacitance values.

In view of the foregoing, disclosed herein are embodiments of a semiconductor structure including a high-density stacked capacitor and, particularly, a stack of parallel-connected capacitors for high capacitance density. The stack can include a diode-type capacitor (also referred to herein as a PN junction capacitor). In different embodiments, the diode-type capacitor has different in-substrate well configurations. For example, in some embodiments, the diode-type capacitor can include a single well region within and at the top surface of a semiconductor substrate. The semiconductor substrate can have a first type conductivity (e.g., P-type conductivity) and the well region can have a second type conductivity (e.g., N-type conductivity). The well region could be rectangular in shape. Alternatively, the well region and the semiconductor substrate could be interdigitated. In other embodiments, the diode-type capacitor can include: a first well region within and at the top surface of the semiconductor substrate; a second well region within and at the top surface of the semiconductor substrate and further laterally surrounding the first well region; and a third well region within the semiconductor substrate and below the first and second well regions.

In these embodiments, the first well region and the semiconductor substrate can have a first type conductivity (e.g., P-type conductivity) and the second and third well regions can have a second type conductivity (e.g., N-type conductivity). Furthermore, the first well region could be rectangular in shape. Alternatively, the first well region and the second well region could be interdigitated. The stack can also include a transistor-type capacitor (e.g., a metal-oxide-semiconductor capacitor (MOSCAP)) on an insulator layer above the diode-type capacitor. Optionally, the stack can further include at least one additional capacitor (e.g., at least one metal-oxide-metal capacitor (MOMCAP)) on a dielectric layer and aligned above the transistor-type capacitor (e.g., in one or more back end of the line (BEOL) metal levels). Also disclosed herein are embodiments of a method of forming the above-described semiconductor structure.

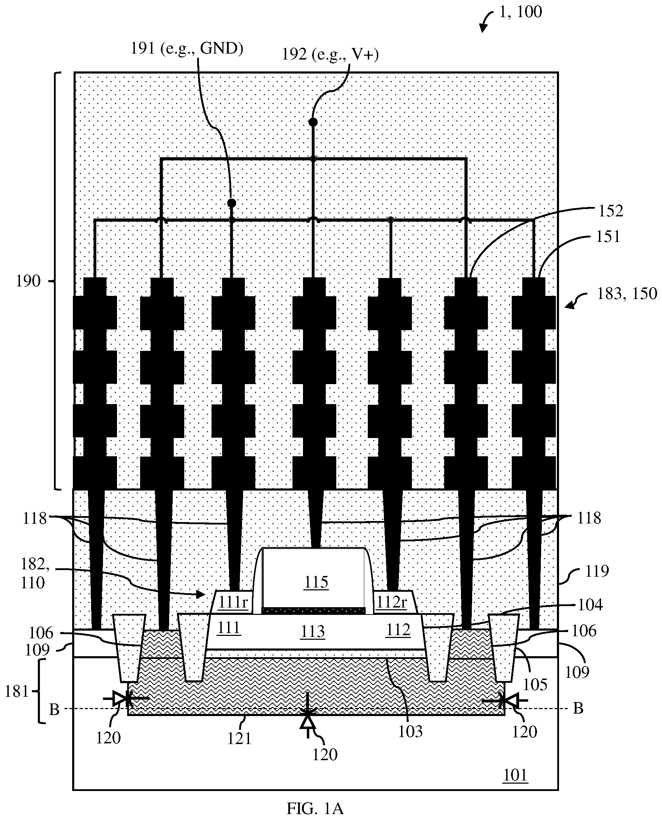

FIGs. 1A-1B, 2A-2C, 3A-3B, and 4A-4C are different cross-section diagrams illustrating disclosed embodiments of a semiconductor structure 1, 2, 3, 4 including a high-density stacked capacitor 100, 200, 300, 400, respectively.

Referring specifically to FIGs. 1A-1B, 2A-2C, 3A-3B, and 4A-4C, in each of the disclosed embodiments, semiconductor structure 1, 2, 3, 4 can be formed using an advanced semiconductor-on-insulator processing technology platform (e.g., a fully depleted silicon-on-insulator (FDSOI) processing technology platform). Semiconductor structure 1, 2, 3, 4 can include a semiconductor substrate 101, 201, 301, 401. Semiconductor substrate 101, 201, 301, 401 can be, for example, a monocrystalline silicon substrate or a substrate of any other suitable monocrystalline semiconductor material (e.g., silicon germanium, etc.). Semiconductor substrate 101, 201, 301, 401 can be doped so as to have a first type conductivity at a relatively low conductivity. For example, semiconductor substrate 101, 201, 301, 401 can be doped so as to have P-type conductivity at a relatively low conductivity level. The first type conductivity can, for example, be P-type conductivity so that semiconductor substrate 101, 201, 301, 401 is a P-semiconductor substrate.

Semiconductor structure 1, 2, 3, 4 can further include an insulator layer 103, 203, 303, 403 on semiconductor substrate 101, 201, 301, 401. Insulator layer 103, 203, 303, 403 can be, for example, a silicon dioxide layer or a layer of any other suitable insulator material.

Semiconductor structure 1, 2, 3, 4 can further include a semiconductor layer 104, 204, 304, 404 on insulator layer 103, 203, 303, 403. Semiconductor layer 104, 204, 304, 404 can be, for example, a monocrystalline silicon layer or a layer of any other suitable monocrystalline semiconductor material (e.g., silicon germanium, etc.).

Semiconductor structure 1, 2, 3, 4 can further include a high-density stacked capacitor 100, 200, 300, 400. High-density stacked capacitor 100, 200, 300, 400 can include a stack of at least two capacitors connected in parallel between a first node 191, 291, 391, 491 and a second node 192, 292, 392, 492. Specifically, high-density stacked capacitor 100, 200, 300, 400 can include: a diode-type capacitor 181, 281, 381, 481 (also referred to herein as a PN-junction capacitor) within semiconductor substrate 101, 201, 301, 401; and a transistor-type capacitor 182, 282, 382, 482 (e.g., a metal-oxide-semiconductor capacitor (MOSCAP), such as an N-channel field effect transistor (NFET) MOSCAP) on insulator layer 103, 203, 303, 403 aligned above and connected in parallel with diode-type capacitor 181, 281, 381, 481. Optionally, high-density stacked capacitor 100, 200, 300, 400 can also include at least one additional capacitor 183, 283, 383, 483 (e.g., a metal-oxide-metal capacitor (MOMCAP)) on a dielectric layer 119, 219, 319, 419 (e.g., in one or more BEOL metal levels) and aligned above and connected in parallel with diode-type capacitor 181, 281, 381, 481 and transistor-type capacitor 182, 282, 382, 482.

More particularly, as illustrated in FIGs. 1A-1B, 2A-2C, 3A-3B, and 4A-4C, high-density stacked capacitor 100, 200, 300, 400 can include a diode-type capacitor 181, 281, 381, 481. For purposes of this disclosure, a diode-type capacitor is a capacitor that includes at least one diode. A diode can include an anode region (and, particularly, a P-type semiconductor region) immediately adjacent to a cathode region (and, particularly, an N-type semiconductor region), thereby forming a PN junction. Additionally, the anode and cathode regions are further appropriately biased so as to generate junction capacitance at the PN junction. Junction capacitance can be generated, as long as the PN junction is not forward biased. Specifically, junction capacitance can form when the anode and cathode regions are biased at the same voltage level and can decrease with reverse biasing. The amount of junction capacitance generated at the PN junction can vary depending upon the bias voltages applied to the anode and the cathode. For example, neutral biasing or low level reverse biasing can create a high resistance depletion region between the anode and cathode regions and thereby create junction capacitance. As reverse biasing is increased, the width of the depletion region between the anode and cathode regions increases and, thus, the junction capacitance decreases. Additional factors that impact the amount of junction capacitance generated can include the length of the PN junction and the dopant-dependent conductivity levels of the anode and cathode regions.

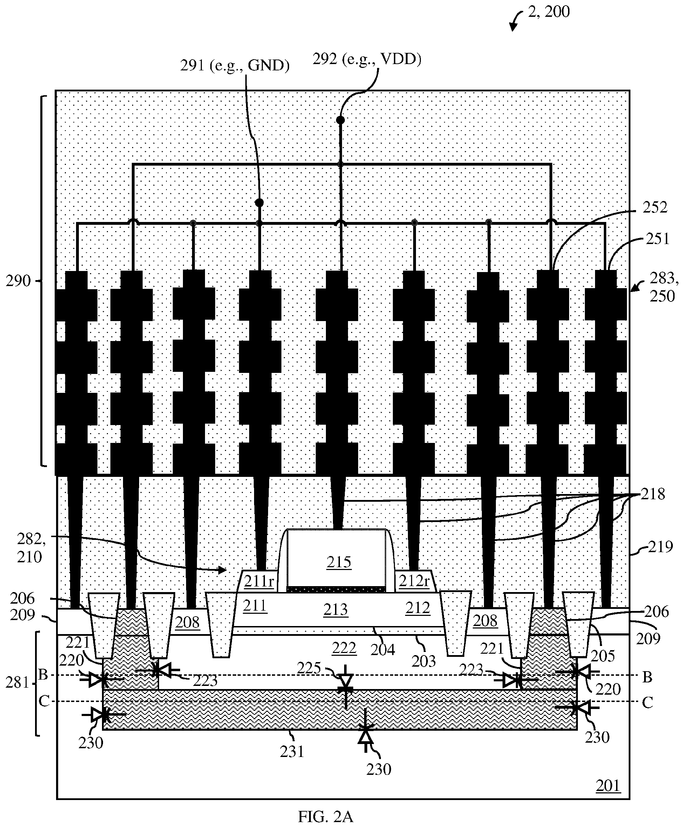

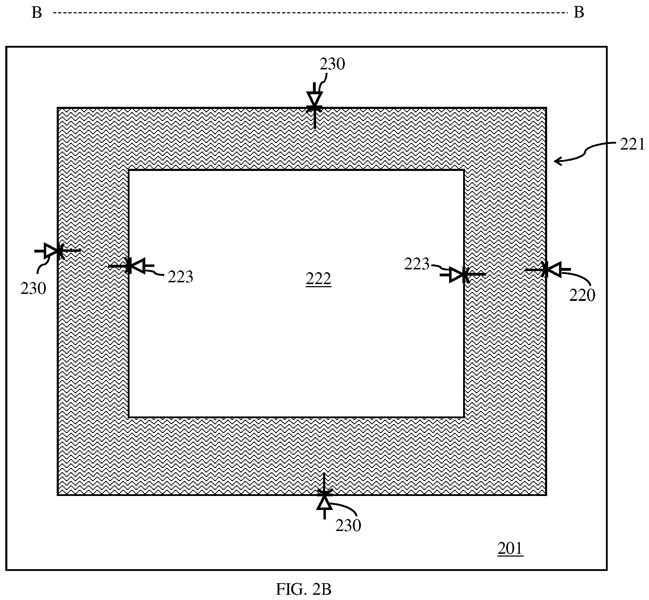

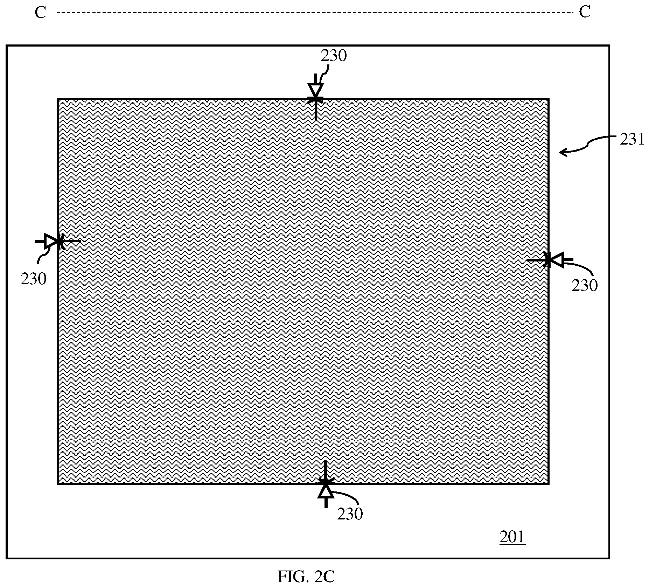

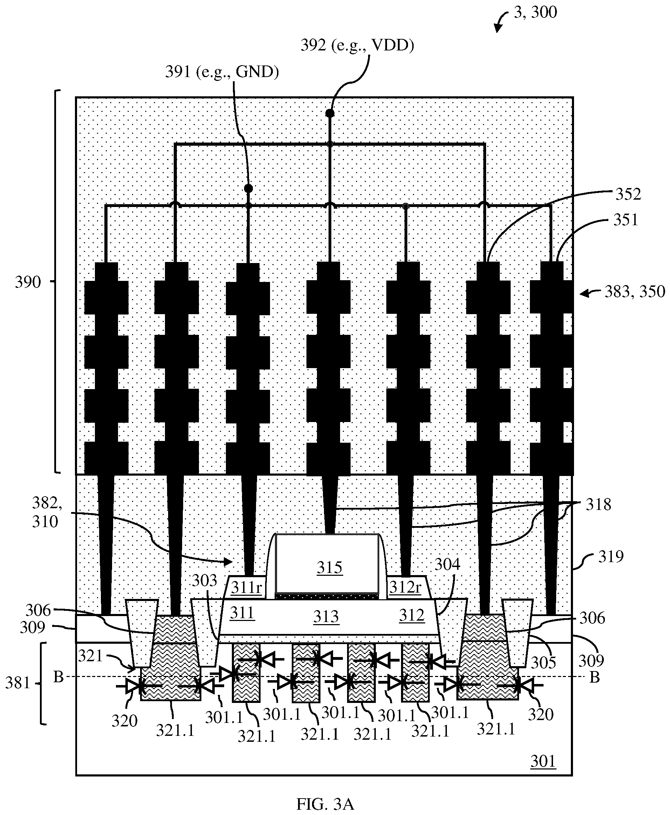

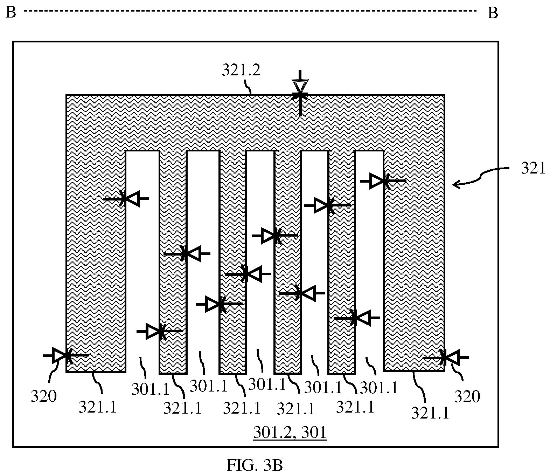

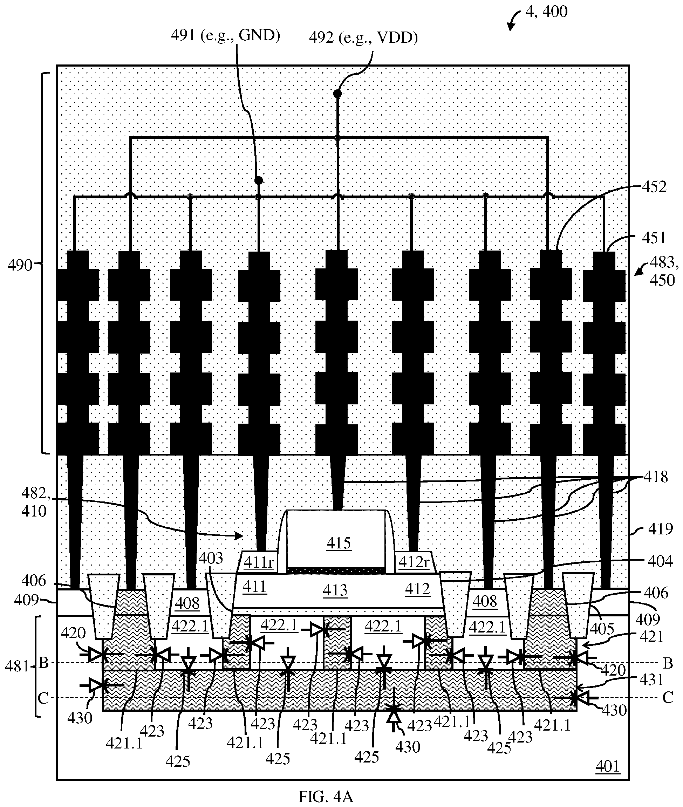

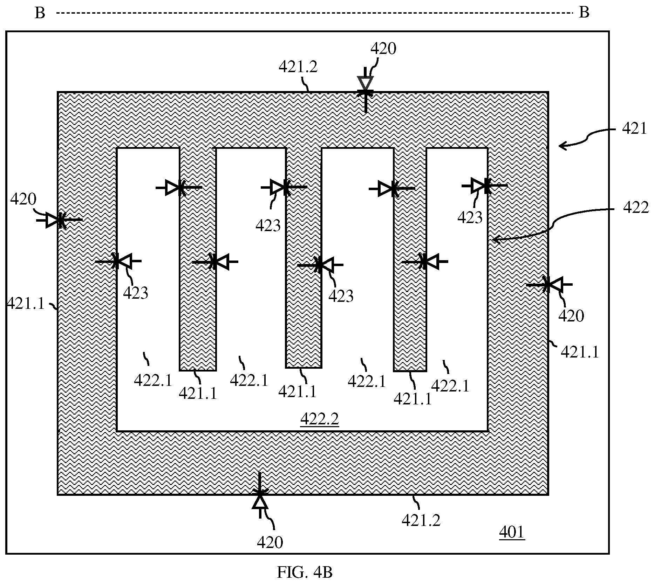

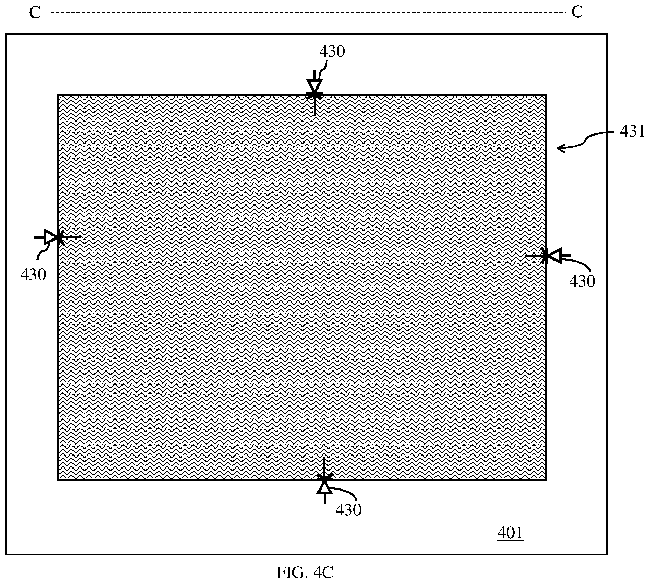

Diode-type capacitor 181 (shown in FIGs. 1A-1B), diode-type capacitor 281 (shown in FIGs. 2A-2C), diode-type capacitor 381 (shown in FIGs. 3A-3B), and diode-type capacitor 481 (shown in FIGs. 4A-4C) can vary with regard to the configurations of in-substrate well region(s) that form the respective diode(s) within which junction capacitance is generated. The different configurations are designed to achieve different amounts of junction capacitance. For purposes of this disclosure, a well region refers to a region of semiconductor material doped (e.g., via a dopant implantation process or any other suitable doping process) so as to have either the first type conductivity (e.g., P-type conductivity) or a second type conductivity (e.g., N-type conductivity) that is different from the first type conductivity. A well region doped so as to have N-type conductivity is referred to herein as a Nwell, whereas a well region doped so as to have P-type conductivity is referred to herein as a Pwell.

Referring specifically to FIGs. 1A-1B and 3A-3B, in some embodiments, a diode-type capacitor 181, 381 can include a single well region 121, 321 within and at the top surface of semiconductor substrate 101, 301. As mentioned above, semiconductor substrate 101, 301 can have the first type conductivity (e.g., P-type conductivity). Well region 121, 321 can have the second type conductivity. For example, well region 121, 321 can be an Nwell within a P-semiconductor substrate. Thus, semiconductor substrate 101, 301 and well region 121, 321 form a diode with a PN junction 120, 320 at all interfaces therebetween (i.e., at the bottom and side boundaries of well region 121, 321). As illustrated, in these embodiments, the shape of well region 121 in diode-type capacitor 181 is different from the shape of well region 321 in diode-type capacitor 381.

For example, as illustrated in FIGs. 1A-1B, well region 121 in diode-type capacitor 181 can have a simple geometric shape. For example, as viewed from the top down or in a horizontal cross-section, well region 121 can have a rectangular shape (as illustrated). However, it should be understood that the figures are not intended to be limiting. Alternatively, as viewed from the top down or in a horizontal cross-section, this well region 121 could have any other simple geometric shape (e.g., a square shape, an oval shape, a round shape, etc.).

Alternatively, as illustrated in FIGs. 3A-3B, well region 321 in diode-type capacitor 381 could have an irregular shape so as to increase the overall size of the PN junction 320 between the semiconductor substrate 301 and well region 321 within the same defined diode-type capacitor area (i.e., to increase capacitance density). For example, as viewed from the top down or in a horizontal cross-section, well region 321 could have a single-sided comb-shape (as illustrated). Such a single-sided comb-shaped well region 321 can include a well body 321.2 and multiple well extensions 321.1 (also referred to herein as well fingers) extending laterally from one side of well body 321.2. Well extensions 321.1 could be parallel to each other and perpendicular to well body 321.2 (as illustrated). Alternatively, well extensions 321.1 could be parallel to each other and angled relative to well body 321.2. In this case, portions of the semiconductor substrate 301 (which have the first type conductivity) abut the bottom and outside boundaries of well region 321 (which has the second type conductivity). Additional portions of the semiconductor substrate (which also have the first type conductivity), namely, semiconductor substrate extensions 301.1 (also referred to herein as substrate fingers) extend laterally between well extensions 321.1 to well body 321.2. Thus, well region 321 and semiconductor substrate 301 are interdigitated.

For purposes of illustration, well region 321 of diode-type capacitor 381 is illustrated as being a single-sided comb-shaped well region. Specifically, well region 321 is illustrated as including six well extensions 321.1 on a single side of well body 321.2. Well extensions 321.1 are illustrated as having equal lengths and as being separated by equal separation distances. Some of the well extensions are illustrated as having different widths. It should be understood that the figures are not intended to be limiting. For example, alternatively, well region 321 could include any number of two or more well extensions 321.1. Alternatively, well extensions 321.1 could extend laterally from opposite sides of well body 321.2 (e.g., to form a dual-sided comb-shape). Alternatively, some well extensions 321.1 could be separated from each other by different separation distances. Alternatively, all well extensions 321.1 could have the same width. Alternatively, some well extensions 321.1 could have different lengths, etc. Furthermore, the irregular well shape of well region 321 could be an irregular shape other than a comb shape (e.g., star-shaped, etc.) designed for increasing capacitance density.

Referring to again to FIGs. 1A-1B and FIGs. 3A-3B, opposite polarity terminals of diode-type capacitor 181, 381 can be connected to different nodes of the high-density stacked capacitor 100, 300. For example, semiconductor substrate 101, 301 (e.g., an anode terminal) can be electrically connected to first node 191, 391 and well region 121, 321 (e.g., a cathode terminal) can be electrically connected to second node 192, 392. Specifically, semiconductor substrate 101, 301 can be electrically connected to first node 191, 391 via one or more substrate contact regions 109, 309 and well region 121, 321 can be electrically connected to second node 192, 392 via one or more well contact regions 106, 306 (also referred to herein as well tap(s)). Those skilled in the art will recognize that semiconductor structures formed using advanced semiconductor-on-insulator processing technology platforms (e.g., FDSOI processing technology platforms) typically include combinations of semiconductor-on-insulator (e.g., silicon-on-insulator (SOI) regions (including a semiconductor layer on an insulator layer above the substrate) and bulk regions (devoid of the insulator layer and the semiconductor layer thereon). Semiconductor-on-insulator regions can include semiconductor-on-insulator devices and bulk regions can include bulk devices. Additionally, the bulk regions can include contact regions that facilitate contacting areas of the semiconductor substrate below the insulator layer. Thus, substrate contact region(s) 109, 309 and well contact region(s) 106, 306 can be located in bulk regions of semiconductor structure 1, 3. Substrate contact region(s) 109, 309 and well contact region(s) 106, 306 can further be electrically isolated from laterally adjacent doped regions by isolation regions 105, 305. Isolation regions 105, 305 can be, for example, shallow trench isolation (STI) structures (as discussed in greater detail below).

Each substrate contact region 109, 309 can be immediately adjacent to the top surface of semiconductor substrate 101, 301 offset from any well region or other doped region therein. Each substrate contact region 109, 309 can include an epitaxial semiconductor layer adjacent to the top surface of semiconductor substrate 101, 301 or an additional doped region within and at the top surface of semiconductor substrate 101, 301. Each substrate contact region 109, 309 can have the same first type conductivity as semiconductor substrate 101, 301, but at a higher conductivity level. Each well contact region 106, 306 can include an epitaxial semiconductor layer adjacent to well region 121, 321 or an additional doped region within well region 121, 321 at the top surface of semiconductor substrate 101, 301. Each well contact region 106, 306 can have the same second type conductivity as well region 121, 321, but at a higher conductivity level. So, for example, if semiconductor substrate 101, 301 is a P- semiconductor substrate and well region 121, 321 is an Nwell, substrate contact region 109, 309 can be a P+ contact region and well contact region 106, 306 can be an N+ contact region. In this case, to form junction capacitance at PN junction 120, 320, first node 191, 391 could be connected to ground (0.0V) (or connected to receive a negative voltage (V-)) and second node 192, 392 could be connected to a positive voltage (V+) (or connected to ground (0.0V)).

Referring specifically to FIGs. 2A-2C and 4A-4C, in still other some embodiments, a diode-type capacitor 281, 481 can include multiple well regions to create a series of PN junctions to further increase capacitance density. Specifically, a diode-type capacitor 281, 481 could include a first well region 222, 422 within and at the top surface of semiconductor substrate 201, 401. As mentioned above, semiconductor substrate 201, 401 can have the first type conductivity (e.g., P-type conductivity). First well region 222, 422 can have the same first type conductivity as semiconductor substrate 201, 401 but at a higher conductivity level. For example, first well region 222, 422 can be a Pwell having a higher P-type conductivity than semiconductor substrate 201, 401.

Diode-type capacitor 281, 481 can further include a second well region 221, 421 and a third well region 231, 431. Second well region 221, 421 can be within and at the top surface of semiconductor substrate 201, 401 and can further laterally surround first well region 222, 422. Third well region 231, 431 (also referred to herein as a buried well region) can be within semiconductor substrate 201, 401 below both first well region 222, 422 and second well region 221, 421, thereby completely isolating the first well region 222, 422 from a lower portion of semiconductor substrate 201, 301. Second well region 221, 421 and third well region 231, 431 can both have a second type conductivity that is different from the first type conductivity. Furthermore, second type conductivity levels of the second well region 221, 421 and third well region 231, 431 can be either the same or different. For example, second well region 221, 421 could be an Nwell and third well region 231, 431 could be a buried Nwell the same or a lower N-type conductivity than the Nwell above.

With this multi-well configuration, diode-type capacitor 281, 481 includes a series of different PN junctions. These PN junctions include: PN junction 223, 423 between first well region 222, 422 and second well region 221, 421; PN junction 225, 425 between first well region 222, 422 and third well region 231, 431; PN junction 220, 420 between semiconductor substrate 201, 401 and second well region 221, 421; and PN junction 230, 430 between semiconductor substrate 201, 401 and third well region 231, 431. Those skilled in the art will recognize that the capacitive properties of PN junctions can vary depending upon doping as well as biasing conditions. Thus, for example, if second well region 221, 421 has a higher conductivity level than third well region 231, 431, then capacitance exhibited at a PN junction 220, 420 (between semiconductor substrate 201, 401 and second well region 221, 421) may be different from capacitance exhibited at a PN junction 230, 430 (between semiconductor substrate 201, 401 and third well region 231, 431) and capacitance exhibited at PN junction 223, 423 (between first well region 222, 422 and second well region 221, 421) may be different from capacitance exhibited at PN junction 225, 425 (between first well region 222, 422 and third well region 231, 431). As illustrated, in these embodiments, the shape of first well region 222 in diode-type capacitor 281 is different from the shape of first well region 422 in diode-type capacitor 481.

For example, as illustrated in FIGs. 2A-2C, first well region 222 in diode-type capacitor 281 can have a simple geometric shape. For example, as viewed from the top down or in a horizontal cross-section, first well region 222 could have a rectangular shape (as illustrated). However, it should be understood that the figures are not intended to be limiting. Alternatively, as viewed from the top down or in a horizontal cross-section, this first well region 222 could have any other simple geometric shape (e.g., a square shape, an oval shape, a round shape, etc.).

Alternatively, as illustrated in FIGs. 4A-4C, first well region 422 of diode-type capacitor 481 could have an irregular shape so as to increase the overall size of the PN junction between the second well region 421 and first well region 422 within the same defined diode-type capacitor area (i.e., so as to increase capacitance density). For example, as viewed from the top down or in a horizontal cross-section, first well region 422 can have a single-sided comb-shape. Single-sided comb-shaped first well region 422 can include a first well body 422.2 and multiple first well extensions 422.1 (also referred to herein as first well fingers) extending laterally from one side of first well body 422.2. Second well region 421 can include a continuous second well body 422.2 that laterally surrounds first well region 422 and multiple second well extensions 421.1 (also referred to herein as second well fingers) that extend laterally between first well extensions 422.1. Thus, first well region 422 and second well region 421 are interdigitated.

For purposes of illustration, first well region 422 in diode-type capacitor 481 is shown as including a single-sided comb-shape. Specifically, first well region 422 is illustrated as having four first well extensions 422.1 on a single side of first well body 422.2. First well extensions 422.1 are illustrated as having equal lengths and equal widths and as being separated by equal separation distances. It should be understood that the figures are not intended to be limiting. For example, alternatively, first well region 422 could include any number of two or more first well extensions 422.1. Alternatively, first well extensions 422.1 could extend laterally from opposite sides of well body 422.2 (e.g., to form a dual-sided comb-shape). Alternatively, some first well extensions 422.1 could be separated from each other by different separation distances. Alternatively, some first well extensions 422.1 could have different lengths and/or different widths. Furthermore, the irregular well shape of first well region 422 shown in FIGs. 4A-4C is not intended to be limiting. Furthermore, the irregular well shape of first well region 422 could be an irregular shape other than a comb shape (e.g., star-shaped, etc.) designed for increasing capacitance density.

Referring again to FIGs. 2A-2C and 4A-4C, opposite polarity terminals of diode-type capacitor 281, 481 can be connected to different nodes of high-density stacked capacitor 200, 400. Specifically, semiconductor substrate 201, 401 and first well region 222, 422 (e.g., anode terminals) can be electrically connected to first node 291, 491 and second well region 221, 421 (and thereby third well region 231, 431) (e.g., cathode terminals) can be electrically connected to second node 292, 492. Specifically, semiconductor substrate 201, 401 can be electrically connected to first node 291, 491 via substrate contact region(s) 209, 409, first well region 222, 422 can be electrically connected to first node 291, 491 via first well contact region(s) 208, 408 (also referred to herein as first well tap(s)), and second well region 221, 421 can be electrically connected to second node 292, 492 via second well contact region(s) 206, 406 (also referred to herein as second well tap(s)). As mentioned above, semiconductor structures formed using advanced semiconductor-on-insulator processing technology platforms (e.g., FDSOI processing technology platforms) typically include combinations of semiconductor-on-insulator (e.g., silicon-on-insulator (SOI) regions (including a semiconductor layer on an insulator layer above the substrate) and bulk regions (devoid of the insulator layer and the semiconductor layer thereon). Semiconductor-on-insulator regions can include semiconductor-on-insulator devices and bulk regions can include bulk devices. Additionally, the bulk regions can include contact regions that facilitate contacting areas of the semiconductor substrate below the insulator layer. Thus, substrate contact region(s) 209, 409, first well contact region(s) 208, 408, and second well contact region(s) 206, 406 can be located in bulk regions of semiconductor structure 2, 3. Each of these contact regions can further be electrically isolated from laterally adjacent doped regions by isolation regions 205, 405. Isolation regions 205, 405 can be shallow trench isolation (STI) structures (as discussed in greater detail below).

Each substrate contact region 209, 409 can be immediately adjacent to semiconductor substrate 201, 401 offset from any well region or other doped region therein. Each substrate contact region 209, 309 can include an epitaxial semiconductor layer adjacent to the top surface of semiconductor substrate 201, 401 or an additional doped region within and at the top surface of semiconductor substrate 201, 401. Each first well contact region 208, 408 can be immediately adjacent to top surface of semiconductor substrate 201, 401 at first well region 222, 422. Each first well contact region 208, 408 can include an epitaxial semiconductor layer adjacent to first well region 222, 422 or an additional doped region within first well region 222, 422 at the top surface of semiconductor substrate 201, 401. Substrate contact region(s) 209, 409 and first well contact region(s) 208, 408 can have the first type conductivity, but at higher conductivity levels than the semiconductor material below. Each second well contact region 206, 406 can be immediately adjacent to top surface of semiconductor substrate 201, 401 at second well region 221, 421. Each second well contact region 206, 406 can include an epitaxial semiconductor layer adjacent to second well region 221, 421 or an additional doped region within second well region 221, 421 at the top surface of semiconductor substrate 201, 401. Second well contact region(s) 206, 406 can have the second type conductivity, but at a higher conductivity level than second well region 221, 421. So, for example, if semiconductor substrate 201, 401 is a P- semiconductor substrate, first well region 222, 422 is a Pwell, and second well region 221, 421 is an Nwell, then substrate contact region(s) 209, 409 and first well contact region(s) 208, 408, can be P+ contact regions and second well contact region 206, 406 can be an N+ contact region. In this case, to form junction capacitance at the different PN junctions mentioned above, first node 291, 491 could be connected to ground (0.0V) (or connected to receive a negative voltage (V-)) and second node 292, 492 could be connected to a positive voltage (V+) (or connected to ground (0.0V)).

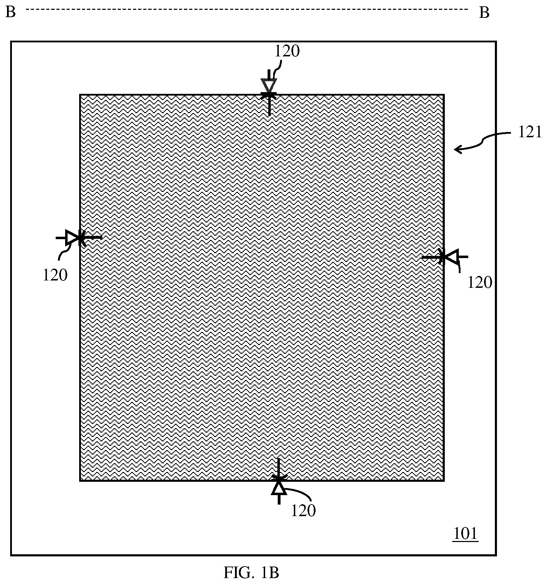

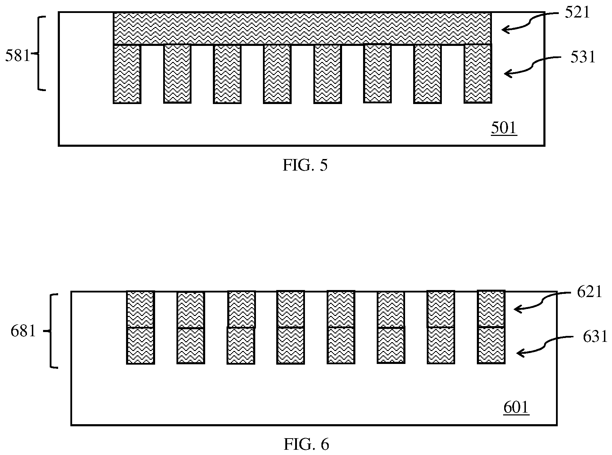

It should be noted that the various in-substrate well configurations of the diode-type capacitors 181, 281, 381, and 481 shown in FIGs. 1A-1B, 2A-2C, 3A-3B, and 4A-4C are provided for illustration purposes. Alternatively, any other suitable in-substrate well configurations for forming a diode-type capacitor could be employed. For example, as illustrated in FIG. 5, a diode-type capacitor 581 in a high-density stacked capacitor structure could include, within a semiconductor substrate 501 with the first type conductivity (e.g., P-type conductivity), a well region 521 and an additional well region 531 both having the second type conductivity (e.g., N-type conductivity). Well region 521 could be adjacent to the top surface of semiconductor substrate 501 and could have a simple geometric shape (e.g., a rectangular, square, oval, etc. shape, as discussed above with regard to well region 121 of FIG. 1). Additional well region 531 could be below first well region 521 (i.e., could be a buried well region) and could have an irregular shape (e.g., a single or double-sided comb shape so as to be interdigitated with portions of semiconductor substrate 501). In yet another example, as illustrated in FIG. 6, a diode-type capacitor 681 in a high-density stacked capacitor structure could include, within a semiconductor substrate 601 with the first type conductivity (e.g., P-type conductivity), a well region 621 and an additional well region 631 both having the second type conductivity (e.g., N-type conductivity). Well region 621 could be adjacent to the top surface of semiconductor substrate 601 and could have an irregular shape (e.g., a single or double-sided comb shape so as to be interdigitated with portions of semiconductor substrate 601). Additional well region 631 could be below well region 621 (i.e., could be a buried well region) and could have the same irregular shape (e.g., a single or double-sided comb shape so as to be interdigitated with portions of semiconductor substrate 601).

Referring again to FIGs. 1A-1B, 2A-2C, 3A-3B and 4A-4C, high-density stacked capacitor 100, 200, 300, 400 can further include a transistor-type capacitor 182, 282, 382, 482 on insulator layer 103, 203, 303, 403 aligned above diode-type capacitor 181, 281, 381, 481. For purposes of this disclosure, a transistor-type capacitor is a capacitor that includes a transistor or a device structure similar to a transistor (e.g., with a gate structure on a semiconductor layer). For example, transistor-type capacitor 182, 282, 382, 482 can be a metal-oxide-semiconductor capacitor (MOSCAP) 110, 210, 310, 410. MOSCAP 110, 210, 310, 410 can be a semiconductor-on-insulator field effect transistor with electrically coupled source/drain regions 111-112, 211-212, 311-312, 411-412. For example, MOSCAP 110, 210, 310, 410 can include a semiconductor-on-insulator N-channel FET (NFET), such as a partially-depleted silicon-on-insulator (PDSOI) NFET or fully-depleted silicon-on-insulator (FDSOI) NFET.

More specifically, MOSCAP 110, 210, 310, 410 can include an active device region within semiconductor layer 104, 204, 204, 404. Boundaries of the active device region can be defined by isolation regions 105, 205, 305, 405. Isolation regions 105, 205, 305, 405 can be, for example, shallow trench isolation (STI) structures. An STI structure can include a trench, which extends vertically through semiconductor layer 104, 204, 304, 404 to and, optionally, through insulator layer 103, 203, 303, 403. The trench can be filled with one or more layers of isolation material (e.g., silicon dioxide, silicon oxynitride, silicon nitride, or any other suitable type of isolation material).

MOSCAP 110, 210, 310, 410 can further include a channel region 113, 213, 313, 413 within semiconductor layer 104, 204, 304, 404 in the active device region and positioned laterally between source/drain regions 111-112, 211-212, 311-312, 411-412 (which are electrically connected, as discussed below). Source/drain regions 111-112, 211-212, 311-312, 411-412 can include portions of semiconductor layer 104, 204, 304, 404. Source/drain regions 111-112, 211-212, 311-312, 411-412 can have second-type conductivity (e.g., N-type conductivity) at a relatively high conductivity level (e.g., can be N+ source/drain regions). Furthermore, channel region 113, 213, 313, 413 can be an intrinsic channel region (i.e., an undoped channel region) or channel region 113, 213, 313, 413 can have first-type conductivity (e.g., P-type conductivity) at a relatively low conductivity level (e.g., can be a P- channel region).

MOSCAP 110, 210, 310, 410 can further include a gate structure 115, 215, 315, 415 (also referred to herein as a front gate) adjacent to the top surface of semiconductor layer 104, 204, 304, 404 at channel region 113, 213, 313, 413. Front gate 115, 215, 315, 415 can include a gate dielectric layer immediately adjacent to the top surface of semiconductor layer 104, 204, 304, 404 at channel region 113, 213, 313, 413. The gate dielectric layer can include one or more layers of gate dielectric material (e.g., a silicon dioxide gate dielectric material, a high-K gate dielectric material, etc.). Front gate 115, 215, 315, 415 can further include a gate conductor layer on the gate dielectric layer. The gate conductor layer can include one or more layers of gate conductor material (e.g., a doped-polysilicon gate conductor material, a metal or metal alloy gate conductor material, etc.). Front gate 115, 215, 315, 415 can have any suitable gate configuration. For example, front gate 115, 215, 315, 415 could be a gate-first silicon dioxide-polysilicon gate structure, a gate-first high-K dielectric-metal gate structure, a replacement metal gate structure, etc. Such gate structures are well known in the art and, thus, the details thereof have been omitted from this specification in order to allow the reader to focus on the salient aspects of the disclosed embodiments. In any case, MOSCAP 110, 210, 310, 410 can further include gate sidewall spacers positioned laterally adjacent to sidewalls of front gate 115,215,315,415.

Optionally, MOSCAP 110, 210, 310, 410 can further include raised source/drain regions 111r-112r, 211r-212r, 311r-312r, 411r-412r on the top surface of semiconductor layer 104, 204, 304, 404 immediately adjacent to source/drain regions 111-112, 211-212, 311-312, 411-412, respectively. Raised source/drain regions 111r-112r, 211r-212r, 311r-312r, 411r-412r can be in situ-doped epitaxial semiconductor layers having the same second-type conductivity (e.g., N-type conductivity) as source/drain regions 111-112, 211-212, 311-312, 411-412. Raised source/drain regions 111r-112r, 211r-212r, 311r-312r, 411r-412r can be physically separated and electrically isolated from front gate 115, 215, 315, 415 by the gate sidewall spacers.

Source/drain regions 111-112, 211-212, 311-312, 411-412 (or, if applicable, contacts to raised source/drain regions 111r-112r, 211r-212r, 311r-312r, 411r-412r) can be electrically connected to first node 191, 291, 392, 491. Additionally, front gate 115, 215, 315, 415 can be electrically connected to second node 192, 292, 392, 492. As mentioned above, first node 191, 291, 391 491 could be connected to ground (0.0V) (or connected to receive a negative voltage (V-)) and second node 192, 292, 392, 492 could be connected to a positive voltage (V+) (or connected to ground).

In high-density stacked capacitor 100, 200, 300, 400, transistor-type capacitor 182, 282, 382, 482 can be covered by a dielectric layer 119, 219, 319, 419. Dielectric layer 119, 219, 319, 419 can be a middle of the line (MOL) dielectric layer including one or more layers of interlayer dielectric (ILD) material. The layer(s) of ILD material can include, for example, an optional conformal etch stop layer (e.g., a conformal silicon nitride layer) and a blanket dielectric layer on the etch stop layer. The blanket dielectric layer can be, for example, a layer of silicon dioxide or a layer of any other suitable ILD material such as borophosphosilicate glass (BPSG) or phosphosilicate glass (PSG). In any case, the top surface of dielectric layer 119, 219, 319, 419 can be essentially planar and MOL contacts 118, 218, 318, 418 can extend vertically through dielectric layer 119, 219, 319, 419 to front gate 115, 215, 315, 415 and source/drain regions 111-112, 211-212, 311-312, 411-412 (or, if applicable, to raised source/drain regions 111r-112r, 211r-212r, 311r-312r, 411r-412r) of MOSCAP 110, 210, 310, 410. MOL contacts 118, 218, 318, 418 can also extend vertically through dielectric layer 119, 219, 319, 419 to the various contact regions mentioned above (e.g., 106, 109 in high-density stacked capacitor of FIGs. 1A-1B; 206, 208, 209 in high-density stacked capacitor 200 of FIGs. 2A-2C; 306, 309 in high-density stacked capacitor 300 of FIGs. 3A-3B; and 406, 408, 409 in high-density stacked capacitor 400 of FIGs. 4A-4C).

Semiconductor structure 1, 2, 3, 4 can further include back end of the line (BEOL) metal levels 190, 290, 390, 490 above dielectric layer 119, 219, 319, 419. BEOL metal levels 190, 290, 390 can include various interconnects (e.g., metal wires and/or vias). These interconnects can complete the above-mentioned electrical connections between diode-type capacitor 181, 281, 381, 481 and first and second nodes 191-192, 291-292, 391-392, 491-492 and further between transistor-type capacitor 182, 282, 382, 482 and first and second nodes 191-192, 291-292, 391-392, 491-492.

Optionally, as illustrated, high-density stacked capacitor 100, 200, 300, 400 can further include at least one additional capacitor 183, 283, 383, 483 stacked above diode-type capacitor 181, 281, 381, 481 and transistor-type capacitor 182, 282, 382, 482 and connected in parallel therewith between first and second nodes 191-192, 291-292, 391-392, 491-492. Specifically, additional capacitor 183, 283, 383, 483 can be formed within BEOL metal levels 190, 290, 390, 490 above dielectric layer 119, 219, 319, 419. Additional capacitor 183, 283, 383, 483 can be any suitable type of BEOL capacitor, such as a metal-oxide-metal capacitor (MOMCAP), or a metal-insulator-metal capacitor (MIMCAP). For purposes of illustration, additional capacitor 183, 283, 383, 483 is shown in the drawings as being a vertical natural capacitor (VNCAP) 150, 250, 350, 450 (also referred to in the art as a vertical parallel plate capacitor (VPPCAP)). This VNCAP 150, 250, 350, 450 can be a MOMCAP and can include, within each of multiple metal levels, interdigitated wires of a first capacitor plate 151, 251, 351, 451 and a second capacitor plate 152, 252, 352, 452; and vias that electrically connect adjacent wires in different metal levels. As illustrated, first capacitor plate 151, 251, 351, 451 can be electrically connected to first node 191, 291, 391, 491 and second capacitor plate 152, 252, 352, 452 can be electrically connected to second node 192, 292, 392, 492. Such BEOL capacitors are well known in the art and, thus, the details thereof have been omitted from this specification in order to allow the reader to focus on the salient aspects of the disclosed embodiments.

A high-density stacked capacitor 100, 200, 300, 400, which is configured as described above, can be employed to achieve greater capacitance values while consuming a smaller amount of chip area. These gains are due, at least in part, to additional capacitance provided by diode-type capacitor 181, 281, 381, 481 with the semiconductor substrate 101, 201, 301, 401. As a result, a relatively high capacitance density is achievable.

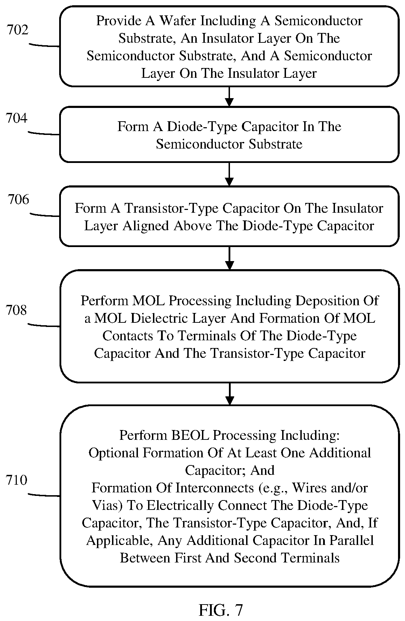

Referring to the flow diagram of FIG. 7, also disclosed herein are embodiments of a method of forming the above-described semiconductor structures (e.g., semiconductor structure 1 of FIGs. 1A-1B, semiconductor structure 2 of FIGs. 2A-2C, semiconductor structure 3 of FIGs. 3A-3B or semiconductor structure 4 of FIGs. 4A-4C), each including a high-density stacked capacitor 100, 200, 300, 400.

The method can begin with a semiconductor-on-insulator wafer (e.g., silicon-on-insulator (SOI) wafer) (see process 702). As illustrated in FIGs. 1A, 2A, 3A, 4A, such a wafer can include a semiconductor substrate 101, 201, 301, 401. Semiconductor substrate 101, 201, 301, 401 can be, for example, a monocrystalline silicon substrate or a substrate of any other suitable monocrystalline semiconductor material (e.g., silicon germanium, etc.). The wafer can further include an insulator layer 103, 203, 303, 403 on semiconductor substrate 101, 201, 301, 401. Insulator layer 103, 203, 303, 403 can be, for example, a silicon dioxide layer or a layer of any other suitable insulator material. The wafer can further include a semiconductor layer 104, 204, 304, 404 on insulator layer 103, 203, 303, 403. Semiconductor layer 104, 204, 304, 404 can be, for example, a monocrystalline silicon layer or a layer of any other suitable monocrystalline semiconductor material (e.g., silicon germanium, etc.). This semiconductor substrate 101, 201, 301, 401 can have a first type conductivity (e.g., P-type conductivity) at a relatively low conductivity level.

The method can include forming, within semiconductor substrate 101, 201, 301, 401, one or more well-regions placed so as to create PN junctions for a diode-type capacitor 181, 281, 381, 481 (see process 704). For example, as illustrated in FIGs. 1A-1B and FIGs. 3A-3B, in some embodiments a diode-type capacitor 181, 381 can be formed at process 704 by forming a single well region 121, 321 with a second type conductivity (e.g., N-type conductivity for a cathode terminal) within and adjacent to the top surface of semiconductor substrate 101, 301 (which has P-type conductivity to function as an anode terminal). As described in detail above with regard to the structure embodiments, the shape of well region 121 can be a simple geometric shape (e.g., a rectangular shape, a square shape, a round shape, an oval shape, as viewed from above or in a horizonal cross-section), whereas the shape of well region 321 can be an irregular shape (e.g., a comb-shape or other irregular shape, as viewed from above or in a horizontal cross-section).

Alternatively, as illustrated in FIGs. 2A-2C and FIGs. 4A-4C, in other embodiments a diode-type capacitor 281, 481 could be created by forming three different well regions within semiconductor substrate 201, 401. Specifically, a first well region 222, 422 with the first type conductivity (e.g., P-type conductivity at a higher conductivity level than the substrate) could be formed within and adjacent to the top surface of semiconductor substrate 201, 401 (e.g., so first well region and semiconductor substrate form anode terminals). A second well region 221, 421 with a second type conductivity (e.g., N-type conductivity for a cathode terminal) could be formed within and at the top surface of semiconductor substrate 201, 401 and laterally surrounding first well region 222, 422. As described in detail above with regard to the structure embodiments, the shape of first well region 222 in diode-type capacitor 281 as shown in FIGs. 2A-2C could be a simple geometric shape (e.g., a rectangular shape, square shape, oval shape, etc.) laterally surrounded by second well region 221, whereas the shape of first well region 422 of diode-type capacitor 481 as shown in FIGs. 4A-4C could be irregular (e.g., comb-shaped) such that the two well regions 421-422 are interdigitated. In any case, a third well region 231, 431 (also referred to herein as a buried well region) with the second type conductivity (e.g., N-type conductivity for a cathode terminal) could be formed semiconductor substrate 201, 401 below the first and second well regions. Optionally, this third well region 231 can have a lower conductivity level than second well region 221, 421.

Techniques for forming well region(s) within a semiconductor substrate are well known in the art and, thus, the details thereof have been omitted from this specification in order to allow the reader to focus on the salient aspects of the disclosed embodiments. However, generally, each well region described above can be formed by performing a masked dopant implantation process. That is, a mask layer can be formed on the wafer. The mask layer can be lithographically patterned and etch to create an opening having a desired shape (e.g., a simple geometric shape or an irregular shape, as discussed above) in a desired location over the semiconductor substrate. A dopant implantation process can then be performed. Specifications for the dopant implantation process (e.g., implantation energy, etc.) can be predetermined to achieve the dopant concentration (and thereby conductivity level) at the desired depth within the semiconductor substrate. It should be noted that such well region(s) can be formed before the insulator layer and the semiconductor layer are formed on the semiconductor substate, between forming the insulator layer and the semiconductor layer on the semiconductor substrate, or after forming the insulator layer and the semiconductor layer on the semiconductor substrate.

The method can further include forming a transistor-type capacitor 182, 282, 382, 482, such as a MOSCAP 110, 210, 310, 410 (e.g., a PDSOI or FDSOI NFET with electrically coupled source/drain regions) on insulator layer 103, 203, 303, 403 aligned above diode-type capacitor 181, 281, 381, 481 (see process 706). During formation of transistor-type capacitor 182, 282, 382, 482, substrate contact region(s) 109, 209, 309, 409 to semiconductor substrate 101, 201, 301, 401 and well contact region(s) 106, 206 and 208, 306, and 406 and 408 to well region(s) 121, 221-222, 321, 421-422 can also be formed. Techniques for forming substrate contact regions and well contact regions (also referred to herein as well taps) and also for forming PDSOI or FDSOI FETs in advanced semiconductor-on-insulator processing technology platforms are well known in the art. Thus, the details thereof have been omitted from this specification in order to allow the reader to focus on the salient aspect of the disclosed embodiments related to stacking of diode-type and transistor-type capacitors one above the other.

The method can further include performing MOL processing (see process 708). For example, a dielectric layer 119, 219, 319, 419 can be formed over the partially completed structure. Dielectric layer 119, 219, 319, 319 can be a MOL dielectric layer including one or more layers of interlayer dielectric (ILD) material. The ILD material layers can include, for example, an optional conformal etch stop layer (e.g., a conformal silicon nitride layer) and a blanket dielectric layer on the etch stop layer. The blanket dielectric layer can be, for example, a layer of silicon dioxide or a layer of any other suitable ILD material such as borophosphosilicate glass (BPSG) or phosphosilicate glass (PSG). Additionally, MOL contacts 118, 218, 318, 418 can be formed such that they extend vertically through dielectric layer 119, 219, 319, 419 to source/drain regions 111-112, 211-212, 311-312, 411-412 of MOSCAP 110, 210, 310, 410 (or, if applicable, contacts to raised source/drain regions 111r-112r, 211r-212r, 311r-312r, 411r-412r) and to each contact region (e.g., substrate contact region(s) 109 and well contact region(s) 106 in FIGs. 1A-1B; second well contact region(s) 206, first well contact region(s) 208, and substrate contact region(s) 209 in FIGs. 2A-2C; well contact region(s) 306 and substrate contact region(s) 309 in FIGs. 3A-3B; and second well contact region(s) 406, first well contact region(s) 408, and substrate contact region(s) 409 in FIGs. 4A-4C)).

The method can further include performing BEOL processing (see process 710). This BEOL processing can include formation of various interconnects (e.g., metal wires and/or vias) to electrically connect diode-type capacitor 181, 281, 381, 481 and transistor-type capacitor 182, 282, 382, 482 in parallel between first and second nodes 191-192, 291-292, 391-392, 491-492 (via previously formed contact regions and MOL contacts in combination with the BEOL interconnects). For example, as illustrated in FIGs. 1A-1B and 3A-3B and described in detail above with regard to the structure embodiments, diode-type capacitor 181, 381 and transistor-type capacitor 182, 382 can be connected in parallel between first node 191, 391 and second node 192, 392 by connecting semiconductor substrate 101, 301 of diode-type capacitor 181, 381 and source/drain regions 111-112, 311-312 of transistor-type capacitor 182, 382 to first node 191, 391 and by connecting well region 121, 321 of diode-type capacitor 181, 381 and front gate 115, 315 of transistor-type capacitor 182, 382 to second node 192, 392. Alternatively, as illustrated in FIGs. 2A-2C and 4A-4C and described in detail above with regard to the structure embodiments, diode-type capacitor 281, 481 and transistor-type capacitor 282, 482 can be connected in parallel between first node 291, 491 and second node 292, 492 by connecting semiconductor substrate 201, 301 and first well region 222, 422 of diode-type capacitor 281, 381 and source/drain regions 211-212, 411-412 of transistor-type capacitor 282, 482 to first node 291, 491 and by connecting second well region 221, 421 of diode-type capacitor 281, 381 and front gate 215, 415 of transistor-type capacitor 282, 482 to second node 292, 492.

Optionally, this BEOL processing can also include formation of at least one additional capacitor 183, 283, 383, 483 within the BEOL metal levels 190, 290, 390, 490 and further aligned above and connected in parallel with diode-type capacitor 181, 281, 381, 481 and transistor-type capacitor 182, 282, 382, 482 between first node 191, 291, 391, 491 and second node 192, 292, 392, 492. Optional additional capacitor(s) 183, 283, 383, 483 can be any suitable type of BEOL capacitor, such as MIMCAP or a MOMCAP (e.g., a VNCAP 150, 250, 350, 450, as illustrated), with a first capacitor plate 151, 251, 351, 451 electrically connected to first node 191, 291, 391, 491 and a second capacitor plate 152, 252, 352, 452 electrically connected to second node 192, 292, 392, 492. Techniques for forming such BEOL capacitors are well known in the art and, thus, the details thereof have been omitted from this specification in order to allow the reader to focus on the salient aspects of the disclosed embodiments.

It should be understood that in the method and structures described above, a semiconductor material refers to a material whose conducting properties can be altered by doping with an impurity. Exemplary semiconductor materials include, for example, silicon-based semiconductor materials (e.g., silicon, silicon germanium, silicon germanium carbide, silicon carbide, etc.) and III-V compound semiconductors (i.e., compounds obtained by combining group III elements, such as aluminum (Al), gallium (Ga), or indium (In), with group V elements, such as nitrogen (N), phosphorous (P), arsenic (As) or antimony (Sb)) (e.g., GaN, InP, GaAs, or GaP). A pure semiconductor material and, more particularly, a semiconductor material that is not doped with an impurity for the purposes of increasing conductivity (i.e., an undoped semiconductor material) is referred to in the art as an intrinsic semiconductor. A semiconductor material that is doped with an impurity for the purposes of increasing conductivity (i.e., a doped semiconductor material) is referred to in the art as an extrinsic semiconductor and will be more conductive than an intrinsic semiconductor made of the same base material. That is, extrinsic silicon will be more conductive than intrinsic silicon; extrinsic silicon germanium will be more conductive than intrinsic silicon germanium; and so on. Furthermore, it should be understood that different impurities (i.e., different dopants) can be used to achieve different conductivity types (e.g., P-type conductivity and N-type conductivity) and that the dopants may vary depending upon the different semiconductor materials used. For example, a silicon-based semiconductor material (e.g., silicon, silicon germanium, etc.) is typically doped with a Group III dopant, such as boron (B) or indium (In), to achieve P-type conductivity, whereas a silicon-based semiconductor material is typically doped with a Group V dopant, such as arsenic (As), phosphorous (P) or antimony (Sb), to achieve N-type conductivity. A gallium nitride (GaN)-based semiconductor material is typically doped with magnesium (Mg) to achieve P-type conductivity and with silicon (Si) or oxygen to achieve N-type conductivity. Those skilled in the art will also recognize that different conductivity levels will depend upon the relative concentration levels of the dopant(s) in a given semiconductor region.

It should be understood that the terminology used herein is for the purpose of describing the disclosed structures and methods and is not intended to be limiting. For example, as used herein, the singular forms "a," "an," and "the" are intended to include the plural forms as well, unless the context clearly indicates otherwise. Additionally, as used herein, the terms "comprises," "comprising," "includes," and/or "including" specify the presence of stated features, integers, steps, operations, elements, and/or components, but do not preclude the presence or addition of one or more other features, integers, steps, operations, elements, components, and/or groups thereof. Furthermore, as used herein, terms such as "right," "left," "vertical," "horizontal," "top," "bottom," "upper," "lower," "under," "below," "underlying," "over," "overlying," "parallel," "perpendicular," etc., are intended to describe relative locations as they are oriented and illustrated in the drawings (unless otherwise indicated) and terms such as "touching," "in direct contact," "abutting," "directly adjacent to," "immediately adjacent to," etc., are intended to indicate that at least one element physically contacts another element (without other elements separating the described elements). The term "laterally" is used herein to describe the relative locations of elements and, more particularly, to indicate that an element is positioned to the side of another element as opposed to above or below the other element, as those elements are oriented and illustrated in the drawings. For example, an element that is positioned laterally adjacent to another element will be beside the other element, an element that is positioned laterally immediately adjacent to another element will be directly beside the other element, and an element that laterally surrounds another element will be adjacent to and border the outer sidewalls of the other element. The corresponding structures, materials, acts, and equivalents of all means or step plus function elements in the claims below are intended to include any structure, material, or act for performing the function in combination with other claimed elements as specifically claimed.

The method as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various disclosed embodiments have been presented for purposes of illustration but are not intended to be exhaustive or limiting. Many modifications and variations will be apparent to those of ordinary skill in the art without departing from the scope and spirit of the disclosed embodiments. The terminology used herein was chosen to best explain the principles of the embodiments, the practical application or technical improvement over technologies found in the marketplace, or to enable others of ordinary skill in the art to understand the embodiments disclosed herein.

In summary, a semiconductor structure and method of forming the semiconductor structure are disclosed. The semiconductor structure includes a high-density stacked capacitor and, particularly, a stack of capacitors connected in parallel between two nodes. The stack includes a diode-type capacitor (also referred to herein as a PN junction capacitor) within a semiconductor substrate. In different embodiments, the diode-type capacitor has different in-substrate well configurations. The stack also includes a transistor-type capacitor (e.g., a metal oxide semiconductor capacitor (MOSCAP)) on an insulator layer aligned above the diode-type capacitor. Optionally, the stack also includes at least one additional capacitor (e.g., at metal-oxide-metal capacitor (MOMCAP)) on a dielectric layer aligned above the transistor-type capacitor (e.g., in one or more back end of the line (BEOL) metal levels). Herein, the following embodiments are explicitly disclosed.
Embodiment 1: A structure comprising:
   a diode-type capacitor in a semiconductor substrate;
   an insulator layer on the semiconductor substrate; and
   a transistor-type capacitor on the insulator layer above the diode-type capacitor, wherein the diode-type capacitor and the transistor-type capacitor are connected in parallel.
   For example, the structure of embodiment 1 may be a capacitor structure.
Embodiment 2: The structure of embodiment 1, wherein the diode-type capacitor includes a well region in the semiconductor substrate adjacent to the insulator layer and wherein the semiconductor substrate has a first type conductivity and the well region has a second type conductivity different from the first type conductivity.
Embodiment 3: The structure of embodiment 2, wherein the well region is rectangular in shape.
Embodiment 4: The structure of embodiment 2 or 3, wherein the well region and the semiconductor substrate are interdigitated.
Embodiment 5: The structure of one of embodiments 1 to 4,
   wherein the diode-type capacitor includes: a first well region in the semiconductor substrate adjacent to the insulator layer; a second well region in the semiconductor substrate and laterally surrounding the first well region; and a third well region in the semiconductor substrate below the first well region and the second well region,
   wherein the first well region and the semiconductor substrate have a first type conductivity, and
   wherein the second well region and the third well region have a second type conductivity different from the first type conductivity.
   In illustrative examples herein in which embodiment 5 is combined with one of embodiments 2 to 5, the well region of embodiment 2 may be understood as representing the first well region of embodiment 5.
Embodiment 6: The structure of embodiment 5, wherein the first well region is rectangular in shape.
Embodiment 7: The structure of embodiment 5 or 6, wherein the first well region and the second well region are interdigitated.
Embodiment 8: The structure of one of embodiments 1 to 7, further comprising:
   a dielectric layer on the transistor-type capacitor; and
   an additional capacitor on the dielectric layer, wherein the additional capacitor is further connected in parallel with the diode-type capacitor and the transistor-type capacitor.
Embodiment 9: A structure comprising:
   a semiconductor substrate with a first type conductivity;
   an insulator layer on the semiconductor substrate;
   a semiconductor layer on the insulator layer; and
   a stacked capacitor including:
      a first node connected to the semiconductor substrate;
      a second node;
      a diode-type capacitor including a well region in the semiconductor substrate adjacent to the insulator layer and electrically connected to the second node, wherein the well region has a second type conductivity different from the first type conductivity; and
      a transistor-type capacitor on the insulator layer above the well region, wherein the transistor-type capacitor includes: a channel region in the semiconductor layer positioned laterally between source/drain regions; and a gate adjacent to the semiconductor layer at the channel region, and wherein the source/drain regions are connected to the first node and the gate is connected to the second node.
   For example, the structure of embodiment 9 may be a stacked capacitor structure or a semiconductor structure. In special illustrative examples herein, the stacked capacitor structure or semiconductor structure may comprise a capacitor structure in accordance with one of embodiments 1 to 8.
Embodiment 10: The structure of embodiment 1, wherein:
   the semiconductor substrate has a first type conductivity;
      the insulator layer is on the semiconductor substrate;
      the structure further comprises:
         a semiconductor layer on the insulator layer; and
         a stacked capacitor including:
            a first node connected to the semiconductor substrate;
            a second node;
            the diode-type capacitor including a well region in the semiconductor substrate adjacent to the insulator layer and electrically connected to the second
         node, wherein the well region has a second type conductivity different from the
         first type conductivity; and
   the transistor-type capacitor on the insulator layer above the well region, wherein the transistor-type capacitor includes: a channel region in the semiconductor layer positioned laterally between source/drain regions; and a gate adjacent to the semiconductor layer at the channel region, and wherein the source/drain regions are connected to the first node and the gate is connected to the second node.
   For example, the structure of embodiment 10 may be a stacked capacitor structure or semiconductor structure. In special illustrative examples herein, the stacked capacitor structure or semiconductor structure may comprise a capacitor structure in accordance with one of embodiments 1 to 8.
Embodiment 11: The structure of embodiment 9 or 10, wherein the well region is rectangular in shape.
Embodiment 12: The structure of one of embodiments 9 to 11, wherein the well region and the semiconductor substrate are interdigitated.
Embodiment 13: The structure of one of embodiments 9 to 12, wherein the semiconductor substrate is a P-type semiconductor substrate, wherein the well region is an N-type well region, and wherein the transistor-type capacitor includes an N-channel field effect transistor.
Embodiment 14: The structure of one of embodiments 9 to 13, wherein the first node is connected to ground and the second node is connected to receive a positive voltage.
Embodiment 15: The structure of one of embodiments 9 to 14, further comprising:
   a P-type substrate contact region adjacent to the P-type semiconductor substrate; and
   an N-type well contact region adjacent to the N-type well region.
Embodiment 16: The structure of one of embodiments 9 to 15, wherein the stacked capacitor further includes:
   a dielectric layer on the transistor-type capacitor; and
   an additional capacitor on the dielectric layer, wherein the additional capacitor is further connected in parallel with the diode-type capacitor and the transistor-type capacitor.
Embodiment 17: A structure comprising:
   a semiconductor substrate with a first type conductivity;
   an insulator layer on the semiconductor substrate;
   a semiconductor layer on the insulator layer; and
   a stacked capacitor including:
      a first node connected to the semiconductor substrate;
      a second node;
      a diode-type capacitor including:
         a first well region in the semiconductor substrate adjacent to the insulator layer, wherein the first well region has the first type conductivity and is connected to the first node;
         a second well region in the semiconductor substrate laterally surrounding the first well region, wherein the second well region has a second type
         conductivity different from the first type conductivity and is connected to the second node; and
         a third well region in the semiconductor substrate below the first well region and the second well region, wherein the third well region has the second type conductivity; and
      a transistor-type capacitor on the insulator layer above the first well region, wherein the transistor-type capacitor includes: channel region in the semiconductor layer positioned laterally between source/drain regions; and a gate adjacent to the semiconductor layer at the channel region, and wherein the source/drain regions are
   connected to the first node and the gate is connected to the second node.
   For example, the structure of embodiment 17 may be a stacked capacitor structure or semiconductor structure. In special illustrative examples herein, the stacked capacitor structure or semiconductor structure may comprise a capacitor structure in accordance with one of embodiments 1 to 8.
Embodiment 18: The structure of embodiment 1, wherein:
   the semiconductor substrate has a first type conductivity;
   the insulator layer is on the semiconductor substrate;
   the structure further comprises:
      a semiconductor layer on the insulator layer; and
      a stacked capacitor including:
         a first node connected to the semiconductor substrate;
         a second node;
         the diode-type capacitor including:
            a first well region in the semiconductor substrate adjacent to the insulator layer, wherein the first well region has the first type conductivity and is connected to the first node;
            a second well region in the semiconductor substrate laterally surrounding the first well region, wherein the second well region has a second type conductivity different from the first type conductivity and is connected to the second node; and
            a third well region in the semiconductor substrate below the first well region and the second well region, wherein the third well region has the second type conductivity; and
         the transistor-type capacitor on the insulator layer above the first well region, wherein the transistor-type capacitor includes: channel region in the semiconductor layer positioned laterally between source/drain regions; and a gate adjacent to the semiconductor layer at the channel region, and wherein the source/drain regions are connected to the first node and the gate is connected to
      the second node.
   For example, the structure of embodiment 18 may be a stacked capacitor structure or semiconductor structure. In special illustrative examples herein, the stacked capacitor structure or semiconductor structure may comprise a capacitor structure in accordance with one of embodiments 1 to 8.
Embodiment 19: The structure of embodiment 17 or 18, wherein the first well region is rectangular in shape.
Embodiment 20: The structure of one of embodiments 17 to 19, wherein the first well region and the second well region are interdigitated.
Embodiment 21: The structure of one of embodiments 17 to 20,
   wherein the semiconductor substrate is a P-type semiconductor substrate,
   wherein the first well region is a P-type well region,
   wherein the second well region and the third well region are N-type well regions, wherein the transistor-type capacitor includes an N-channel field effect transistor, wherein the first node is connected to ground, and
   wherein the second node is connected to receive a positive voltage.
Embodiment 22: The structure of one of embodiments 17 to 21, wherein the stacked capacitor further includes:
   a dielectric layer on the transistor-type capacitor; and
   an additional capacitor on the dielectric layer, wherein the additional capacitor is further connected in parallel with the diode-type capacitor and the transistor-type capacitor.
   At least in the embodiments above, the term "include" and its variants may be interpreted as meaning that an embodiment includes stated features, while not necessarily excluding the presence of other features that are not explicitly stated.

## Claims

1. A semiconductor structure, comprising:
a diode-type capacitor in a semiconductor substrate;
an insulator layer on the semiconductor substrate; and
a transistor-type capacitor on the insulator layer above the diode-type capacitor, wherein the diode-type capacitor and the transistor-type capacitor are connected in parallel.

2. The structure of claim 1, wherein the diode-type capacitor includes a well region in the semiconductor substrate adjacent to the insulator layer and wherein the semiconductor substrate has a first type conductivity and the well region has a second type conductivity different from the first type conductivity.

3. The structure of claim 2, wherein:
the well region is rectangular in shape; and/or
the well region and the semiconductor substrate are interdigitated.

4. The structure of claim 1,
wherein the diode-type capacitor includes: a first well region in the semiconductor substrate adjacent to the insulator layer; a second well region in the semiconductor substrate and laterally surrounding the first well region; and a third well region in the semiconductor substrate below the first well region and the second well region,
wherein the first well region and the semiconductor substrate have a first type conductivity, and
wherein the second well region and the third well region have a second type conductivity different from the first type conductivity.

5. The structure of claim 4, wherein:
the first well region is rectangular in shape; and/or
the first well region and the second well region are interdigitated.

6. The structure of claim 1, wherein:
the semiconductor substrate has a first type conductivity;
the insulator layer is on the semiconductor substrate;
the structure further comprises:
a semiconductor layer on the insulator layer; and
a stacked capacitor including:
a first node connected to the semiconductor substrate;
a second node;
the diode-type capacitor including a well region in the semiconductor substrate adjacent to the insulator layer and electrically connected to the second node, wherein the well region has a second type conductivity different from the first type conductivity; and
the transistor-type capacitor on the insulator layer above the well region, wherein the transistor-type capacitor includes: a channel region in the semiconductor layer positioned laterally between source/drain regions; and a gate adjacent to the semiconductor layer at the channel region, and wherein the source/drain regions are connected to the first node and the gate is connected to the second node.

7. The structure of claim 6, wherein:
the well region is rectangular in shape; and/or
the well region and the semiconductor substrate are interdigitated.

8. The structure of claim 6 or 7, wherein the semiconductor substrate is a P-type semiconductor substrate, wherein the well region is an N-type well region, and wherein the transistor-type capacitor includes an N-channel field effect transistor.

9. The structure of claim 8, wherein the first node is connected to ground and the second node is connected to receive a positive voltage.

10. The structure of claim 8 or 9, further comprising:
a P-type substrate contact region adjacent to the P-type semiconductor substrate; and
an N-type well contact region adjacent to the N-type well region.

11. The structure of claim 1, wherein:
the semiconductor substrate has a first type conductivity;
the insulator layer is on the semiconductor substrate;
the structure further comprises:
a semiconductor layer on the insulator layer; and
a stacked capacitor including:
a first node connected to the semiconductor substrate;
a second node;
the diode-type capacitor including:
a first well region in the semiconductor substrate adjacent to the insulator layer, wherein the first well region has the first type conductivity and is connected to the first node;
a second well region in the semiconductor substrate laterally surrounding the first well region, wherein the second well region has a second type conductivity different from the first type conductivity and is connected to the second node; and
a third well region in the semiconductor substrate below the first well region and the second well region, wherein the third well region has the second type conductivity; and
the transistor-type capacitor on the insulator layer above the first well region, wherein the transistor-type capacitor includes: channel region in the semiconductor layer positioned laterally between source/drain regions; and a gate adjacent to the semiconductor layer at the channel region, and wherein the source/drain regions are connected to the first node and the gate is connected to the second node.

12. The structure of claim 11, wherein the first well region is rectangular in shape.

13. The structure of claim 11 or 12, wherein the first well region and the second well region are interdigitated.

14. The structure of one of claims 11 to 13,
wherein the semiconductor substrate is a P-type semiconductor substrate,
wherein the first well region is a P-type well region,
wherein the second well region and the third well region are N-type well regions,
wherein the transistor-type capacitor includes an N-channel field effect transistor,
wherein the first node is connected to ground, and
wherein the second node is connected to receive a positive voltage.

15. The structure of one of claims 1 to 14, further comprising:
a dielectric layer on the transistor-type capacitor; and
an additional capacitor on the dielectric layer, wherein the additional capacitor is further connected in parallel with the diode-type capacitor and the transistor-type capacitor.
